(19) Europäisches Patentamt
European Patent Office
Office européen des brevets

(11) **EP 1 837 919 A2**

(12) **EUROPÄISCHE PATENTANMELDUNG**

(43) Veröffentlichungstag:
**26.09.2007 Patentblatt 2007/39**

(51) Int Cl.:
*H01L 31/02* (2006.01)     *H01L 31/105* (2006.01)

(21) Anmeldenummer: **07003348.5**

(22) Anmeldetag: **16.02.2007**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **23.03.2006 DE 102006013461**

(71) Anmelder: **Prüftechnik Dieter Busch AG**
**85737 Ismaning (DE)**

(72) Erfinder: **Lysen, Heinrich**
**85748 Garching (DE)**

(74) Vertreter: **Epping - Hermann - Fischer**
**Patentanwaltsgesellschaft mbH**
**Ridlerstrasse 55**
**80339 München (DE)**

(54) **Photodetektoranordnung, Messanordnung mit einer Photodetektoranordnung und Verfahren zum Betrieb einer Messanordnung**

(57)     Eine Photodetektoranordnung (1) umfasst einen Halbleiterkörper (2) mit einem Substrat (3), einer ersten, einer zweiten und einer dritten Schicht (11, 21, 22). Die erste Schicht (11) ist an einer ersten Hauptfläche (10) des Halbleiterkörpers (2), der geeignet zum Empfang einfallender, zu detektierender Photonenstrahlung (ΦL) ist, angeordnet. Die zweite Schicht (21) ist an einer zweiten Hauptfläche (20) des Halbleiterkörpers (2) angeordnet, die zu der ersten Hauptfläche (10) entfernt liegt. Die dritte Schicht (22) ist zwischen dem Substrat (3) und der zweiten Schicht (21) angeordnet.

FIG. 1

EP 1 837 919 A2

**Beschreibung**

Die vorliegende Erfindung betrifft eine Photodetektoranordnung, eine Messanordnung mit einer Photodetektoranordnung, ein Verfahren zum Betrieb einer Messanordnung und ein Verfahren zur Herstellung einer Photodetektoranordnung.

Photodetektoranordnungen werden beispielsweise zur Bestimmung einer Position des Auftreffsortes eines Lichtstrahls eingesetzt. Dabei werden PN-Dioden und PIN-Dioden verwendet.

Das Dokument WO 84/04960 zeigt einen positionssensitiven Detektor in einer Vorrichtung zum Feststellen von Fluchtungsfehlern hintereinander angeordneter Wellen.

Das Dokument EP 0513444 A1 beschreibt ein positionssensitives Bauelement mit einer PN-Diode, wobei eine dünne P-dotierte Schicht an zwei Stellen kontaktiert ist. Trifft der Lichtstrahl näher bei einem ersten der beiden Anschlüsse der P-dotierten Schicht als bei einem zweiten der beiden Anschlüsse auf, so ist bei dem ersten Anschluss ein höherer Strom als bei dem zweiten Anschluss abgreifbar.

Die Dokumente US 4,887,140, US 4,874,939 und US 2004/0135224 A1 zeigen Photodetektoranordnungen, mit denen eine x- und eine y-Koordinate des Auftreffortes eines Lichtstrahls auf der Photodetektoranordnung bestimmt werden kann.

Aufgabe der vorliegenden Erfindung ist es, eine Photodetektoranordnung, eine Messanordnung mit der Photodetektoranordnung, ein Verfahren zum Betrieb einer Messanordnung und ein Verfahren zur Herstellung einer Photodetektoranordnung bereitzustellen, die eine Verringerung des Einflusses von Streustrahlung ermöglichen.

Diese Aufgabe wird mit den Gegenständen der Patentansprüche 1 und 11 sowie den Verfahren gemäß Patentansprüchen 19 und 20 gelöst. Weiterbildungen und Ausgestaltungen sind jeweils Gegenstand der abhängigen Ansprüche.

Erfindungsgemäß umfasst eine Photodetektoranordnung einen Halbleiterkörper mit einem Substrat, einer ersten, einer zweiten und einer dritten Schicht. Die erste Schicht ist an einer ersten Hauptfläche und die zweite Schicht ist an einer zweiten Hauptfläche des Halbleiterkörpers angeordnet. Die zweite Hauptfläche des Halbleiterkörpers liegt der ersten Hauptfläche gegenüber. Die dritte Schicht ist zwischen dem Substrat und der zweiten Schicht angeordnet. Die zweite Schicht weist einen ersten Leitungstyp und die dritte Schicht weist einen zweiten Leitungstyp auf, welcher sich von dem ersten Leitungstyp unterscheidet.

Der Halbleiterkörper ist zum Empfang einfallender, zu detektierender Lichtstrahlung geeignet. Eine Lichtstrahlung erzeugt Elektronen-Loch-Paare, die vor allem in Raumladungszonen zur elektrischen Leitfähigkeit beitragen. Ein Detektorstrom fließt durch die erste Schicht und das Substrat. Ein Teil des Detektorstroms fließt über die zweite Schicht und ein weiterer Teil über die dritte Schicht ab. Zusätzlich zu der zu detektierenden Lichtstrahlung kann eine Streustrahlung auf den Halbleiterkörper auftreffen.

Mit Vorteil ist die dritte Schicht dazu vorgesehen, den von der Streustrahlung erzeugten Strom abzuleiten. An der zweiten Schicht kann ein Messstrom abgegriffen werden, der nur eine geringe Abhängigkeit von der Streustrahlung aufweist.

In einer Ausführungsform ist das Substrat als intrinsischer Halbleiter ausgebildet. Daher kann eine geringe Spannung zwischen der ersten und der dritten Schicht ausreichend sein, um das Substrat von beweglichen Ladungsträgern frei zu räumen und eine Raumladungszone bereitzustellen.

Die erste Schicht kann als lichtdurchlässige Metallschicht, insbesondere als dünne Goldschicht, oder als lichtdurchlässige Halbleiterschicht, insbesondere als Indium-Zinn-Oxyd Schicht ausgebildet sein. In einer alternativen Ausführungsform weist die erste Schicht ein Material des Substrates auf und ist als halbleitende Schicht des ersten Leitungstyps ausgebildet.

Der Halbleiterkörper kann ein halbleitendes Material wie Gallium-Arsenid, Indium-Gallium-Arsenid, Indium-Phosphit, Germanium, Quecksilber-Cadmium-Tellurid umfassen. In einer anderen Ausführungsform weist der Halbleiterkörper Silizium als Material auf.

Der erste Leitungstyp kann als ein P oder stark P dotiertes Halbleitermaterial und der zweite Leitungstyp als ein N oder stark N dotiertes Halbleitermaterial ausgebildet sein. Alternativ kann der erste Leitungstyp als ein N oder stark N dotiertes und der zweite Leitungstyp als ein P oder stark P dotiertes Halbleitermaterial realisiert sein.

Die zweite Schicht kann hochohmig ausgebildet sein. Die zweite Schicht kann beispielsweise einen Schichtwiderstand zwischen 1 und 9 kOhm pro Quadrat, englisch kOhm per square, aufweisen. Bevorzugt weist die zweite Schicht einen Schichtwiderstand von näherungsweise 5 kohm pro Quadrat auf. In einer Ausführungsform zeigt die dritte Schicht einen höheren Schichtwiderstand als die zweite Schicht. Die dritte Schicht kann beispielsweise einen Schichtwiderstand zwischen 10 und 100 kohm pro Quadrat aufweisen. Ist ein Schichtwiderstand der dritten Schicht höher als ein Schichtwiderstand der zweiten Schicht, dann wird ein kleinerer Teil des Detektorstroms über die dritte Schicht verglichen mit der zweiten Schicht abgeführt. Bevorzugt weist die dritte Schicht einen Schichtwiderstand von näherungsweise 30 kohm pro Quadrat auf.

In einer Weiterbildung weist die Photodetektoranordnung einen ersten Messanschluss auf, der mit der zweiten Schicht gekoppelt ist. Der erste Messanschluss kann zur elektrischen Kontaktierung der zweiten Schicht von außerhalb des Halbleiterkörpers ausgebildet sein. In einer Weiterbildung weist die Photodetektoranordnung einen zweiten Messanschluss, der mit der zweiten Schicht gekoppelt und ebenfalls zur elektrischen Kontaktierung der zweiten Schicht von außerhalb ausgelegt ist. Der erste und der zweite Messanschluss können sich nahe einem umlaufenden Rand der zweiten Schicht befinden. Dabei sind der erste und der zweite Messanschluss voneinander entfernt auf der zweiten Hauptfläche angeordnet.

In einer Weiterbildung weist die Photodetektoranordnung einen dritten und vierten Messanschluss auf. Diese sind mit der zweiten Schicht gekoppelt und ebenfalls zur elektrischen Kontaktierung der zweiten Schicht ausgebildet. Sie befinden sich an zwei weiteren voneinander entfernt liegenden Bereichen nahe dem Rand der zweiten Schicht. Eine gedachte Verbindungslinie zwischen dem ersten und dem zweiten Messanschlusses kann sich mit einer gedachten Verbindungslinie zwischen dem dritten und dem vierten Messanschlusses kreuzen. Die beiden Verbindungslinien können sich in einem Winkel von näherungsweise 90 Grad kreuzen. Bevorzugt sind die beiden Verbindungslinien als Geraden ausgebildet.

In einer Ausführungsform nach dem vorgeschlagenen Prinzip kann eine Messanordnung die Photodetektoranordnung und eine Schaltungsanordnung umfassen. Die Schaltungsanordnung ist mit einem Gesamtstromanschluss der ersten Schicht verbunden, an dem ein erstes Potential bereitgestellt ist. Darüber hinaus ist die Schaltungsanordnung mit dem ersten Messanschluss der zweiten Schicht, an dem ein zweites Potential abgreifbar ist, und mit einem Kompensationsanschluss der dritten Schicht verbunden, an dem ein drittes Potential abgreifbar ist.

Das erste und das dritte Potential sind derart eingestellt, dass ein PN-Übergang zwischen der ersten und der dritten Schicht in Sperrrichtung gepolt ist. Somit kann das Substrat, welches sich zwischen der ersten und der dritten Schicht befindet, von freien Ladungsträgern weitgehend freigeräumt sein, so dass eine im Substrat absorbierte Photonenstrahlung eine messbare Erhöhung einer Ladungsträgerkonzentration im Substrat und damit des Detektorstroms erzeugt. Das zweite und das dritte Potential können derart eingestellt sein, dass auch ein PN-Übergang zwischen der zweiten und der dritten Schicht in Sperrrichtung geschaltet ist.

In einer Weiterbildung weist die Schaltungsanordnung eine erste Strommessschaltung zur Ermittlung eines durch den ersten Messanschluss fließenden Stroms auf. Die erste Strommessschaltung kann als Strom-/Spannungsumsetzer realisiert sein, der eingangsseitig mit dem ersten Messanschluss verbunden ist. In einer Ausführungsform umfasst der Strom-/Spannungsumsetzer einen ersten Verstärker, der an einem ersten Eingang mit dem ersten Messanschluss, an einem zweiten Eingang mit einem Bezugspotentialanschluss und an einem Ausgang über eine erste Rückkoppelimpedanz mit dem ersten Eingang verbunden ist. Am Ausgang des ersten Verstärkers ist eine erste Ausgangsspannung bereitgestellt.

In einer Weiterbildung weist die Schaltungsanordnung eine zweite, eine dritte und eine vierte Strommessschaltung auf, die jeweils mit dem zweiten, dem dritten beziehungsweise dem vierten Messanschluss verbunden ist. In einer Ausführungsform ist die jeweilige Strommessschaltung als Strom-/Spannungsumsetzer ausgebildet.

In einer Weiterbildung umfasst die Schaltungsanordnung eine Stromquelle, die mit einem Kompensationsanschluss, der mit der dritten Schicht gekoppelt ist, verbunden ist und zum Bereitstellen eines Kompensationsstroms dient. In einer Ausführungsform ist die Stromquelle derart ausgelegt, dass der Kompensationsstrom ein vorgebbares Verhältnis zu der Summe der durch die Messanschlüsse fließenden Ströme aufweist. Das Verhältnis kann in einer Designphase eingestellt werden. In einer Ausführungsform weist die Stromquelle eine erste Impedanz und eine Diode auf, die zwischen den Ausgang der ersten Strommessschaltung und den Kompensationsanschluss geschaltet ist.

In einer alternativen Ausführungsform weist die Photodetektoranordnung einen zweiten, einen dritten und einen vierten Kompensationsanschluss auf, die mit der dritten Schicht gekoppelt sind. Die vier Kompensationsanschlüsse sind randseitig an der Photodetektoranordnung angeordnet. Die Schaltungsanordnung kann eine zweite, eine dritte und eine vierte Stromquelle aufweisen, die mit dem zweiten, dem dritten beziehungsweise dem vierten Kompensationsanschluss gekoppelt sind. Dabei kann der Wert eines Stromes, der jeweils durch einen der Kompensationsanschlüsse fließt, näherungsweise gleich sein. Alternativ werden unterschiedliche Stromwerte eingeprägt.

Die Messanordnung kann zur Bestimmung einer Position des Auftrefforts eines auf die Photodetektoranordnung auftreffenden Lichtstrahls eingesetzt werden. Sie kann zur Bestimmung einer Position entlang einer Koordinate eingesetzt sein. Sie kann alternativ zur Bestimmung einer x- und einer y-Koordinate der Position des Auftrefforts verwendbar sein. Die Messanordnung kann zum Feststellen von Fluchtungsfehlern hintereinander angeordneter Wellen eingesetzt werden.

Erfindungsgemäß sieht ein Verfahren zum Betrieb einer Messanordnung mit einer Photodetektoranordnung folgende Schritte vor: Die Photodetektoranordnung wird mit einem Lichtstrahl bestrahlt. Elektronen-Loch-Paare werden im Halbleiterkörper der Photodetektoranordnung mittels des Lichtstrahls generiert. Die freien Elektronen und die freien Löcher werden als Detektorstrom abgeführt. Der Detektorstrom wird ermittelt. Ein Kompensationsstrom wird der Photodetektoranordnung mit einem Wert zugeleitet, der ein vorgegebenes Verhältnis zu einem Wert des Detektorstroms aufweist. Somit wird mit Vorteil ein Kompensationsstrom der Photodetektoranordnung zugeführt, der näherungsweise einem durch ein Streulicht erzeugten Detektorstrom entspricht. Ein Messstrom wird an der Photodetektoranordnung abgegriffen, der den Wert der Differenz zwischen dem Detektorstrom und dem Kompensationsstrom aufweist und mit Vorteil näherungsweise unabhängig von der Streustrahlung ist.

In einer Ausführungsform fließt der Detektorstrom durch eine erste Schicht, die an einer ersten Hauptfläche des Halbleiterkörpers angeordnet ist. Bevorzugt fließt der Detektorstrom durch eine zweite Schicht, die an einer zweiten Hauptfläche des Halbleiterkörpers angeordnet ist. Der Kompensationsstrom kann mit Vorteil einer dritten Schicht, die im Halbleiterkörper zwischen der zweiten Schicht und dem Substrat angeordnet ist, zugeleitet werden.

Erfindungsgemäß sieht ein Verfahren zur Herstellung einer Photodetektoranordnung folgende Schritte vor: Ein Halbleiterkörper mit einem Substrat wird bereitgestellt. Dotieratome werden in den Halbleiterkörper an einer ersten Hauptfläche des Halbleiterkörpers eingebracht. Dotieratome werden ebenfalls in den Halbleiterkörper an einer zweiten Hauptfläche des Halbleiterkörpers eingebracht. Die zweite Hauptfläche liegt der ersten Hauptfläche gegenüber. Darüber hinaus werden weitere Dotierstoffe in den Halbleiterkörper an der zweiten Hauptfläche eingebracht. Ein Temperschritt wird zur Diffusion der Dotierstoffe im Halbleiterkörper durchgeführt. Mittels der Dotierungsschritte und der Temperung werden eine erste Schicht an der ersten Hauptfläche, eine zweite Schicht an der zweiten Hauptfläche und eine dritte Schicht zwischen dem Substrat und der zweiten Schicht erzeugt. Die erste, die zweite und die dritte Schicht werden mit Anschlüssen zur elektrischen Kontaktierung von außen versehen.

In einer Ausführungsform weist die zweite Schicht einen ersten Leitungstyp und die dritte Schicht einen zweiten Leitungstyp auf. Der zweite Leitungstyp ist dem ersten Leitungstyp entgegengesetzt. Die erste Schicht kann bevorzugt den ersten Leitungstyp aufweisen.

In einer Ausführungsform erfolgen die Dotierungsschritte als Ionenimplantationsschritte. In einer Weiterbildung wird die Temperung zusammen mit einem Oxidationsschritt durchgeführt.

Die Erfindung wird nachfolgend an mehreren Ausführungsbeispielen anhand der Figuren näher erläutert. Funktions- beziehungsweise wirkungsgleiche Schichten, Anordnungen und Bauelemente tragen gleiche Bezugszeichen. Insoweit sich Schichten, Anordnungen oder Bauelemente in ihrer Funktion entsprechen, wird deren Beschreibung nicht in jeder der folgenden Figuren wiederholt.

Figur 1  zeigt eine beispielhafte Ausführungsform einer Photodetektoranordnung im Querschnitt mit einer Schaltungsanordnung nach dem vorgeschlagenen Prinzip,

Figur 2  zeigt eine beispielhafte Ausführungsform der Photodetektoranordnung aus Figur 1 in Aufsicht nach dem vorgeschlagenen Prinzip und

Figur 3  zeigt eine weitere beispielhafte Ausführungsform einer Schaltungsanordnung.

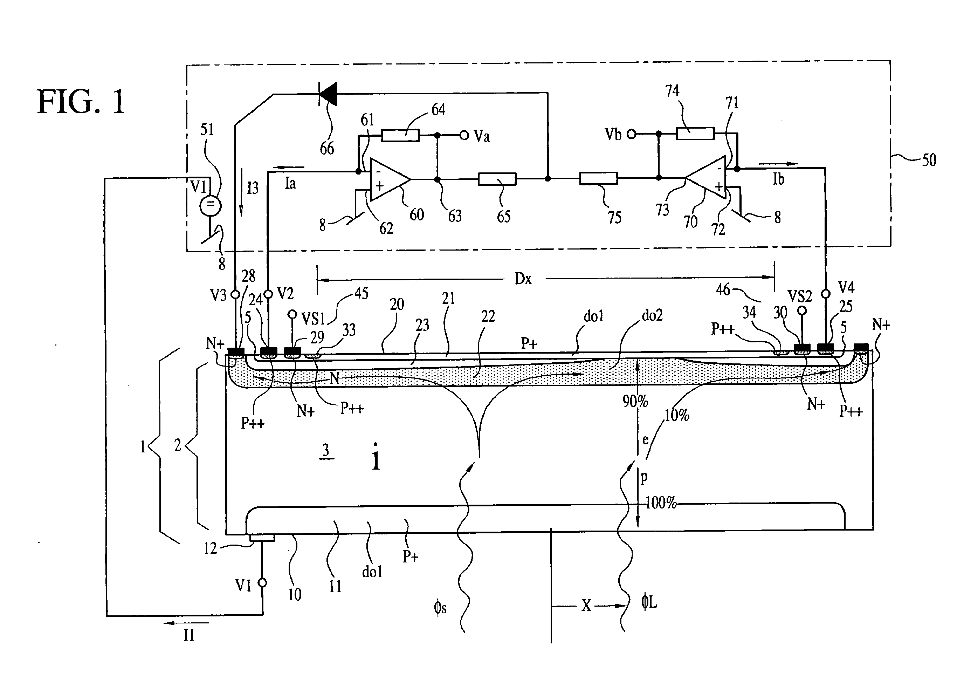

Figur 1 zeigt eine beispielhafte Ausführungsform einer Photodetektoranordnung 1 nach dem vorgeschlagenen Prinzip in Querschnittsdarstellung zusammen mit einer Schaltungsanordnung 50. Die Photodetektoranordnung 1 weist einen Halbleiterkörper 2 mit einem Substrat 3 sowie einer ersten Hauptfläche 10 und einer zweiten Hauptfläche 20 auf, die zu der ersten Hauptfläche 10 entfernt liegt. Eine erste Schicht 11 ist in dem Halbleiterkörper 2 an der ersten Hauptfläche 10 angeordnet. Auf der ersten Schicht 11 ist ein Gesamtstromanschluss 12 angeordnet. Der Halbleiterkörper 2 umfasst eine zweite Schicht 21, die im Halbleiterkörper 2 an der zweiten Hauptfläche 20 angeordnet ist. Darüber hinaus umfasst der Halbleiterkörper 2 eine dritte Schicht 22, die zwischen der zweiten Schicht 21 und dem Substrat 3 vorgesehen ist. Auf der zweiten Schicht 21 ist ein erster und ein zweiter Messanschluss 24, 25 angeordnet, die voneinander entfernt jeweils an einem umlaufenden Rand 5 der zweiten Schicht 21 liegen. Die dritte Schicht 22 ist an den Rändern des gezeigten Ausschnitts des Halbleiterkörpers 2 mit der zweiten Hauptfläche 20 verbunden. Auf ihr ist ein Kompensationsanschluss 28 angeordnet. Der Halbleiterkörper 2 weist einen ersten und einen zweiten Transistor 45, 46 auf, welche die zweite Schicht 21 mit dem ersten und dem zweiten Messanschluss 24, 25 koppeln. Der erste Transistor 45 umfasst einen ersten Steueranschluss 29 und einen ersten Drainbereich 33. Entsprechend umfasst der zweite Transistor 46 einen zweiten Steueranschluss 30 und einen zweiten Drainbereich 34. Die erste und die zweite Schicht 11, 21 sind als stark P oder alternativ als P-dotierte Schichten realisiert. Die dritte Schicht 22 ist als N-dotierte Schicht und das Substrat 3 ist als eigenleitender Halbleiter ausgebildet. Der Halbleiterkörper 2 weist Silizium als Material auf.

Die Schaltungsanordnung 50 weist eine Spannungsquelle 51 auf, die mit dem Gesamtstromanschluss 12 verbunden ist. Weiter umfasst die Schaltungsanordnung 50 einen ersten Verstärker 60, der an einem ersten Eingang 61 mit dem ersten Messanschluss 24 und über eine erste Rückkoppelimpedanz 64 mit einem Ausgang 63 des Verstärkers 60 verbunden ist. Entsprechend weist die Schaltungsanordnung 50 einen zweiten Verstärker 70 auf, der an einem ersten Anschluss 71 mit dem zweiten Messanschluss 25 und über eine zweite Rückkoppelimpedanz 74 mit einem Ausgang 73 des Verstärkers 70 verbunden ist. Ein zweiter Eingang 62 des ersten Verstärkers 60 und ein zweiter Eingang 72 des zweiten Verstärkers 70 sind mit einem Bezugspotentialanschluss 8 verbunden. Der Ausgang 63 des ersten Verstärkers 60 und der Ausgang 73 des zweiten Verstärkers 70 sind über eine erste beziehungsweise eine zweite Impedanz 65, 75 mit einem Knoten verbunden, der mittels einer Diode 66 mit dem Kompensationsanschluss 28 gekoppelt ist.

Mit dem Gesamtstromanschluss 12 wird die erste Schicht 11, mit dem ersten und dem zweiten Messanschluss 24, 25 die zweite Schicht 21 und mit dem Kompensationsanschluss 28 die dritte Schicht 22 kontaktiert. An dem Gesamtstromanschluss 12 ist ein erstes Potential V1, an dem ersten Messanschluss 24 ein zweites Potential V2, an dem zweiten Messanschluss 25 ein viertes Potential V4 und an dem Kompensationsanschluss 28 ein drittes Potential V3 bereitgestellt. Das zweite Potential V2 ist kleiner als das dritte Potential V3 eingestellt, so dass eine erste Raumladungszone 23 zwischen der zweiten und der dritten Schicht 21, 22 ausgebildet wird. Das erste Potential V1 ist kleiner als das dritte Potential V3 eingestellt, so dass das Substrat 3 zwischen der ersten Schicht 11 und der dritten Schicht 22 ebenfalls als Raumladungszone ausgebildet ist. Eine auf der Photodetektoranordnung 1 auftreffende Lichtstrahlung ΦL wird innerhalb des Halbleiterkörpers 2 absorbiert und erzeugt Elektronen-Loch-Paare. Elektronen e und Löcher p, die in dem Substrat 3 zwischen der ersten Schicht 11 und der dritten Schicht 22 generiert werden, tragen zu einem Detektorstrom I1 bei, der durch den Gesamtstromanschluss 12 fließt. Ein Wert des Detektorstroms I1 entspricht der Summe der Werte eines ersten Messstroms IA, der durch den ersten Messanschluss 24 fließt, eines zweiten Messstroms IB, der durch den zweiten Messanschluss 25 fließt, und eines Kompensationsstroms I3, der durch den Kompensationsanschluss 28 fließt.

Die Spannungsquelle 51 stellt das erste Potential V1 mit einem Wert bereit, der negativ gegenüber dem Bezugspotential an dem Bezugspotentialanschluss 8 ist, so dass zwischen der ersten Schicht 11 und der dritten Schicht 22 eine Raumladungszone ausgebildet ist. Der erste und der zweite Verstärker 60, 70 dienen zur Umwandlung des ersten und des zweiten Messstroms Ia, Ib in eine erste beziehungsweise zweite Ausgangsspannung Va, Vb, die an den Ausgängen 63, 73 der beiden Verstärker 60, 70 bereitgestellt werden. Der erste Eingang 61 ist invertierend gegenüber dem zweiten Eingang 62 des ersten Verstärkers 60 geschaltet; entsprechend ist der erste Eingang 71 des zweiten Verstärkers 70 invertierend gegenüber dem zweiten Eingang 72 geschaltet. Trifft der Lichtstrahl ΦL die Photodetektoranordnung 1 näher an dem ersten Messanschluss 24 als an dem zweiten Messanschluss 25, so weist der erste Messstrom Ia einen höheren Wert als der zweite Messstrom Ib auf. Die x-Koordinate der Position des Auftreffens des Lichtstrahls auf die Photodetektoranordnung 1 kann näherungsweise mit folgender Gleichung bestimmt werden:

$$x = \frac{Dx}{2}\frac{Ia - Ib}{Ia + Ib} = \frac{Dx}{2}\frac{Va - Vb}{Va + Vb},$$

wobei Ia und Ib der erste beziehungsweise der zweite Messstrom, Va und Vb die erste beziehungsweise die zweite Ausgangsspannung und Dx ein Abstand zwischen dem ersten und dem zweiten Messanschluss 24, 25 ist. Sowohl der Lichtstrahl ΦL als auch eine Streustrahlung Φs können Elektronen-Loch-Paare erzeugen. Beispielhaft ist eine Streustrahlung Φs mit der Leistung 0,01 mW eingezeichnet, die zu einem Strom in der Größenordnung von 1 μA in der dritten Schicht 22 zu dem außen liegenden Kompensationsanschluss 28 führt. Ein Lichtstrahl ΦL mit einer Energie von beispielsweise 0,1 mW und einer Wellenlänge von beispielsweise 635 nm trifft ebenfalls auf die Photodetektoranordnung 1 und erzeugt Elektronen-Loch-Paare. Ein Verhältnis des Kompensationsstroms I3 zur Summe aus dem ersten und dem zweiten Messstrom Ia, Ib ist derart eingestellt, dass der Kompensationsstrom I3 dem durch die Streustrahlung ΦS erzeugten Anteil im Detektorstrom I1 entspricht. Die erste und die zweite Rückkoppelimpedanz 64, 74 sowie die erste und die zweite Impedanz 65, 75 können als Widerstand ausgebildet sein. Die beiden Rückkoppelimpedanzen 64, 74 können beispielsweise einen Widerstandswert von 30 kohm und die beiden Impedanzen 65, 75 einen Widerstandswert von 300 kOhm aufweisen, so dass der Kompensationsstrom I3 etwa 10% des Wertes der Summe aus erstem und zweiten Messstrom Ia, Ib aufweist. Somit fließt der von der Streustrahlung Φs erzeugte Detektorstromanteil über den Kompensationsanschluss 28 ab. Dazu fließt der Kompensationsstrom I3 vom Ausgang 63 des ersten Verstärkers 60 über die erste Impedanz 65 und vom Ausgang 73 des zweiten Verstärkers 70 über die zweite Impedanz 75 zu der Diode 66 und damit zu dem Kompensationsanschluss 28. Die dritte Schicht 22 ist niedriger als die zweite Schicht 21 dotiert, so dass ein Hauptteil des Detektorstroms I1 durch die dritte Schicht 22 hindurch zur zweiten Schicht 21 fließt.

Der erste und der zweite Steueranschluss 29, 30 werden mit einem ersten beziehungsweise einem zweiten Steuerpotential VS1, VS2 beaufschlagt. Ist mittels des ersten und des zweiten Steuerpotentials VS1, VS2 der erste und der zweite Transistor 45, 46 in einen sperrenden Zustand geschaltet, so fließt weder der erste Messstrom Ia noch der zweite Messstrom Ib. Somit wird die x-Koordinate des Auftreffens des Lichtstrahls in diesem Betriebszustand nicht detektiert. Sind jedoch der erste und der zweite Transistor 45, 46 mittels des ersten und des zweiten Steuerpotentials VS1, VS2 in Durchlass geschaltet, so kann der erste und der zweite Messstrom Ia, Ib fließen.

Somit kann mit Vorteil aus der Höhe des ersten und des zweiten Messstroms Ia, Ib eine Position des Auftreffens des Lichtstrahls ΦL ermittelt werden. Mit Vorteil kann mittels des Kompensationsstroms I3 ein Einfluss der Streustrahlung Φs verringert werden.

In einer alternativen Ausführungsform weist die Photodetektoranordnung 50 einen zweiten Kompensationsanschluss auf, der mit der dritten Schicht 22 verbunden und an einem umlaufenden Rand in einem von dem ersten Kompensationsanschluss 28 entfernten Bereich angeordnet ist. Ein Anschluss der Diode 66 kann unmittelbar mit dem ersten und dem zweiten Kompensationsanschluss verbunden oder über eine Schaltung zur Aufteilung des Kompensationsstroms I3 gekoppelt sein.

Alternativ können der erste und der zweite Drainbereich 33, 34 entfallen.

In einer alternativen Ausführungsform können der erste und der zweite Transistor 45, 46 entfallen. Die Photodetektoranordnung 1 weist in dieser alternativen Ausführungsform den ersten und den zweiten Messanschluss 24, 26 auf, nicht jedoch den ersten und den zweiten Steueranschluss 29, 30 sowie den ersten und den zweiten Drainbereich 33, 34.

In einer alternativen Ausführungsform sind die erste Schicht 11 und die zweite Schicht 21 als N dotierter sowie die dritte Schicht 22 als P dotierter Bereich ausgebildet.

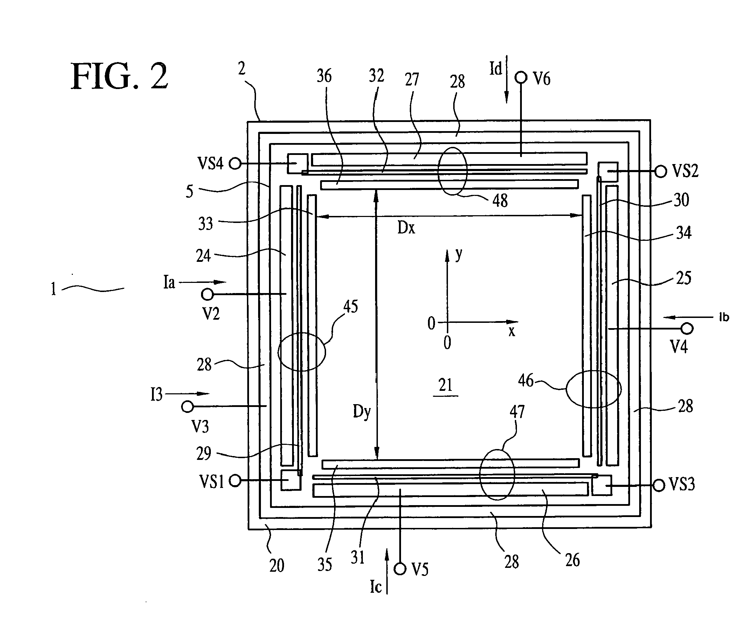

Figur 2 zeigt eine beispielhafte Ausführungsform der Photodetektoranordnung 1 gemäß Figur 1 in Aufsicht auf die zweite Hauptfläche 20. Die zweite Hauptfläche 20 weist die zweite Schicht 21 auf, die rechteckig, insbesondere quadratisch ausgebildet sein kann. Der erste Messanschluss 24 ist als Streifen entlang des Randes 5 der zweiten Schicht 21 ausgebildet. Entsprechend sind auch ein zweiter, ein dritter und ein vierter Messanschluss 25, 26, 27 jeweils als Streifen an dem Rand 5 der zweiten Schicht 21 vorgesehen. Die vier Messanschlüsse 24 bis 27 sind auf Rändern eines Rechteckes angeordnet. Der erste und der zweite Messanschluss 24, 25 sind voneinander entfernt angeordnet. Entsprechend sind der dritte und der vierte Messanschluss 26, 27 ebenfalls entfernt voneinander angeordnet. Eine gedankliche Verbindungslinie des ersten Messanschlusses 24 zum zweiten Messanschluss 25 kreuzt eine gedankliche Verbindungslinie des dritten Messanschlusses 26 zum vierten Messanschluss 27. Die vier Messanschlüsse 24 bis 27 sind jeweils elektrisch von außen kontaktiert, so dass ein zweites, ein viertes, ein fünftes beziehungsweise ein sechstes Potential V2, V4, V5, V6 an ihnen abgreifbar ist. Um die zweite Schicht 21 und damit um die vier Messanschlüsse 24 bis 27 herum ist streifenförmig der Kompensationsanschluss 28 vorgesehen, der elektrisch von außen zur Zuführung eines dritten Potentials V3 kontaktiert ist. Die Photodetektoranordnung 1 weist vier Transistoren 45 bis 48 auf. Der erste Transistor 45 umfasst den ersten Steueranschluss 29 und den ersten Drainbereich 33. Entsprechend sind der zweite, der dritte und der vierte Transistor 46, 47, 48 ausgebildet.

Über den Kompensationsanschluss 28 wird der Photodetektoranordnung 1 der Kompensationsstrom I3 zugeleitet. Wird der erste und der zweite Transistor 45, 46 in Durchlass geschaltet, kann mittels des ersten und des zweiten Messstroms Ia, Ib die x-Koordinate der Position des Auftreffens des Lichtstrahls ermittelt werden. Die y-Koordinate kann ermittelt werden, sobald der erste und der zweite Transistor 45, 46 in einen sperrenden Betriebszustand und der dritte und der vierte Transistor 47, 48 in Durchlass geschaltet sind und ein Wert des dritten Messstroms Ic und ein Wert des vierten Messstroms Id ermittelt werden.

Alternativ können die vier Drainbereiche 33 bis 36 im Halbleiterkörper 2 miteinander leitend verbunden sein, so dass sie als ein Streifen ausgebildet sind.

Alternativ können die vier Drainbereiche 33 bis 36 entfallen.

In einer anderen Ausführungsform können die vier Transistoren 45 bis 48 und damit die vier Steueranschlüsse 29 bis 32 sowie die vier Drainbereiche 33 bis 36 entfallen. Die x- und die y-Koordinaten sind somit gleichzeitig ermittelbar.

In einer alternativen Ausführungsform weist die Photodetektoranordnung 1 einen zweiten, einen dritten und einen vierten Kompensationsanschluss auf, die mit der dritten Schicht 22 gekoppelt und randseitig an der Photodetektoranordnung 1 in voneinander entfernten Bereichen angeordnet sind.

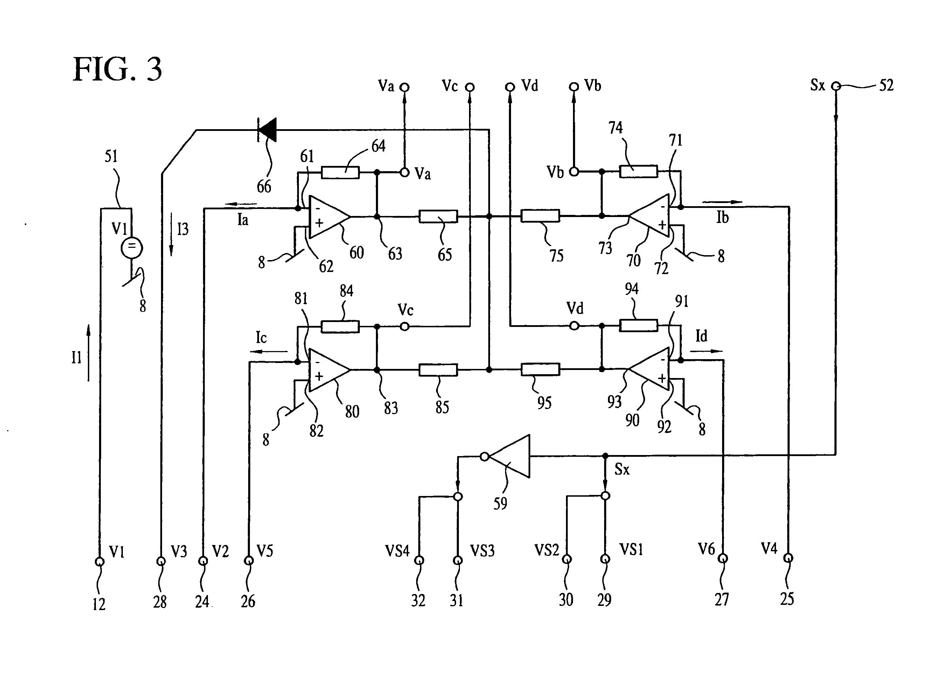

Figur 3 zeigt eine beispielhafte Ausführungsform einer Schaltungsanordnung 50 nach dem vorgeschlagenen Prinzip, die eine Weiterbildung der Schaltungsanordnung gemäß Figur 1 darstellt. Zusätzlich zu der Schaltungsanordnung 50 gemäß Figur 1 weist die Schaltungsanordnung 50 gemäß Figur 3 einen Inverter 59 auf, der an einem Eingang mit einem Eingang 52 der Schaltungsanordnung 50 verbunden ist. Der erste und der zweite Steueranschluss 29, 30 sind an den Eingang des Inverters 59 und der dritte und der vierte Steueranschluss 31, 32 sind an einen Ausgang des Inverters 59 angeschlossen. Weiter weist die Schaltungsanordnung 50 einen dritten und einen vierten Verstärker 80, 90 auf, die mit dem dritten beziehungsweise vierten Messanschluss 26, 27 eingangsseitig verbunden sind und an ihrem Ausgang ein drittes beziehungsweise viertes Ausgangssignal Vc, Vd bereitstellen.

An dem Eingang 52 der Schaltungsanordnung 50 wird ein Taktsignal Sx zugeführt. Mittels des Inverters 59 wird erreicht, dass der erste und der zweite Transistor 45, 46 abwechselnd mit dem dritten und dem vierten Transistor 47, 48 sperrend beziehungsweise in Durchlass geschaltet sind. Die y-Koordinate kann näherungsweise gemäß folgender Gleichung ermittelt werden:

$$y = \frac{Dy}{2}\frac{Ic - Id}{Ic + Id} = \frac{Dy}{2}\frac{Vc - Vd}{Vc + Vd} \quad ,$$

wobei Ic der dritte und Id der vierte Messstrom, Vc die dritte und Vd die vierte Ausgangsspannung sowie Dy ein Abstand zwischen dem dritten und dem vierten Messanschluss 26, 27 sind.

In einer alternativen Ausführungsform weist die Schaltungsanordnung eine Stromaufteilungsschaltung auf, die die Diode 66 mit dem ersten, einem zweiten, einem dritten und einem vierten Kompensationsanschluss koppelt. Die Stromaufteilungsschaltung kann vier Widerstände umfassen, die an einem ersten Anschluss mit der Diode 66 und an einem zweiten Anschluss mit jeweils einem der vier Kompensationsanschlüsse verbunden sind. Die Widerstände können näherungsweise den gleichen Wert aufweisen, so dass der Wert eines Stromes, der jeweils durch einen der vier Kompensationsanschlüsse fließt, näherungsweise gleich sein kann.

Bezugszeichenliste

| | |
|---|---|
| 1 | Photodetektoranordnung |
| 2 | Halbleiterkörper |
| 3 | Substrat |
| 5 | Rand |
| 10 | erste Hauptfläche |
| 11 | erste Schicht |
| 12 | Gesamtstromanschluss |
| 20 | zweite Hauptfläche |
| 21 | zweite Schicht |
| 22 | dritte Schicht |
| 23 | erste Raumladungszone |
| 24 | erster Messanschluss |
| 25 | zweiter Messanschluss |
| 26 | dritter Messanschluss |
| 27 | vierter Messanschluss |
| 28 | Kompensationsanschluss |
| 29 | erster Steueranschluss |
| 30 | zweiter Steueranschluss |
| 31 | dritter Steueranschluss |
| 32 | vierter Steueranschluss |
| 33 | erster Drainbereich |
| 34 | zweiter Drainbereich |
| 35 | dritter Drainbereich |
| 36 | vierter Drainbereich |
| 45 | erster Transistor |
| 46 | zweiter Transistor |
| 47 | dritter Transistor |
| 48 | vierter Transistor |
| 50 | Schaltungsanordnung |
| 51 | Spannungsquelle |
| 52 | Eingang |
| 59 | Inverter |
| 60 | erster Verstärker |
| 61 | erster Eingang |
| 62 | zweiter Eingang |
| 63 | Ausgang |
| 64 | erste Rückkoppelimpedanz |
| 65 | erste Impedanz |
| 66 | Diode |
| 70 | zweiter Verstärker |
| 71 | erster Eingang |
| 72 | zweiter Eingang |
| 73 | Ausgang |
| 74 | zweite Rückkoppelimpedanz |
| 75 | zweite Impedanz |
| 80 | dritter Verstärker |
| 81 | erster Eingang |
| 82 | zweiter Eingang |
| 83 | Ausgang |
| 84 | dritte Rückkoppelimpedanz |
| 85 | dritte Impedanz |
| 90 | vierter Verstärker |
| 91 | erster Eingang |
| 92 | zweiter Eingang |
| 93 | Ausgang |
| 94 | vierte Rückkoppelimpedanz |
| 95 | vierte Impedanz |
| do1 | erster Leitungstyp |
| do2 | zweiter Leitungstyp |
| Dx | Abstand in x-Richtung |
| Dy | Abstand in y-Richtung |
| e | Elektron |
| I1 | Detektorstrom |
| I3 | Kompensationsstrom |
| Ia | erster Messstrom |
| Ib | zweiter Messstrom |
| Ic | dritter Messstrom |
| Id | vierter Messstrom |
| N | negativ dotiert |
| P | positiv dotiert |
| p | Loch |
| Sx | Taktsignal |
| Va | erste Ausgangsspannung |
| Vb | zweite Ausgangsspannung |
| Vc | dritte Ausgangsspannung |
| Vd | vierte Ausgangsspannung |
| V1 | erstes Potential |
| V2 | zweites Potential |
| V3 | drittes Potential |
| V4 | viertes Potential |
| V5 | fünftes Potential |
| V6 | sechstes Potential |
| VS1 | erstes Steuerpotential |
| VS2 | zweites Steuerpotential |
| VS3 | drittes Steuerpotential |
| VS4 | viertes Steuerpotential |
| x, y | Koordinate |

**Patentansprüche**

1. Photodetektoranordnung, umfassend einen Halbleiterkörper (2) mit

- einem Substrat (3),
- einer ersten Schicht (11) an einer ersten Hauptfläche (10) des Halbleiterkörpers (2), der zum Empfang einer einfallenden, zu detektierenden Photonenstrahlung (ΦL) geeignet ist,

- einer zweiten Schicht (21) mit einem ersten Leitungstyp (do1) an einer zweiten Hauptfläche (20) des Halbleiterkörpers (2), die zu der ersten Hauptfläche (10) entfernt liegt, und

- einer dritten Schicht (22), die einen zweiten Leitungstyp (do2), welcher dem ersten Leitungstyp (do1) entgegengesetzt ist, aufweist und zwischen dem Substrat (3) und der zweiten Schicht (21) angeordnet ist.

**2.** Photodetektoranordnung nach Anspruch 1,
**dadurch gekennzeichnet, dass**
das Substrat (3) als intrinsischer Halbleiter ausgebildet ist.

**3.** Photodetektoranordnung nach Anspruch 1 oder 2,
**dadurch gekennzeichnet, dass**
die erste Schicht (11) den ersten Leitungstyp (do1) aufweist.

**4.** Photodetektoranordnung nach einem der Ansprüche 1 bis 3,
**dadurch gekennzeichnet, dass**
die zweite Schicht (21) hochohmig ausgebildet ist.

**5.** Photodetektoranordnung nach einem der Ansprüche 1 bis 4,
**dadurch gekennzeichnet, dass**
die zweite Schicht (21) einen Schichtwiderstand zwischen 1 und 9 kOhm/Quadrat aufweist.

**6.** Photodetektoranordnung nach einem der Ansprüche 1 bis 5,
**dadurch gekennzeichnet, dass**
die dritte Schicht (22) einen höheren Schichtwiderstand als die zweite Schicht (21) aufweist.

**7.** Photodetektoranordnung nach Anspruch 5 oder 6,
**dadurch gekennzeichnet, dass**
die dritte Schicht (22) einen Schichtwiderstand zwischen 10 und 100 kohm/Quadrat aufweist.

**8.** Photodetektoranordnung nach einem der Ansprüche 1 bis 7,
**dadurch gekennzeichnet, dass**
die Photodetektoranordnung (1) einen ersten Messanschluss (24) aufweist, der auf der zweiten Schicht (21) an der zweiten Hauptfläche (20) angeordnet und zur elektrischen Kontaktierung der zweiten Schicht (21) von außerhalb der Photodetektoranordnung (1) ausgebildet ist.

**9.** Photodetektoranordnung nach Anspruch 8,
**dadurch gekennzeichnet, dass**
die Photodetektoranordnung (1) einen zweiten Messanschluss (24) aufweist, der zur elektrischen Kontaktierung der zweiten Schicht (21) von außerhalb der Photodetektoranordnung (1) ausgebildet ist und auf der zweiten Schicht (21) an der zweiten Hauptfläche (20) randseitig an einem zu dem ersten Messanschluss (24) entfernt liegenden Bereich angeordnet ist.

**10.** Photodetektoranordnung nach Anspruch 9,
**dadurch gekennzeichnet, dass**
die Photodetektoranordnung (1) einen dritten und einen vierten Messanschluss (26, 27) aufweist, die zur elektrischen Kontaktierung der zweiten Schicht (21) ausgebildet sind und die auf der zweiten Schicht (21) an der zweiten Hauptfläche (20) jeweils randseitig in zwei weiteren voneinander entfernt liegenden Bereichen derart angeordnet sind, dass sich eine gedachte Verbindungslinie von dem dritten zu dem vierten Messanschluss (26, 27) und eine gedachte Verbindungslinie von dem ersten zu dem zweiten Messanschluss (24, 25) kreuzen.

**11.** Messanordnung, umfassend die Photodetektoranordnung (1) nach einem der Ansprüche 8 bis 10 und eine Schaltungsanordnung (50), die mit

- einem Gesamtstromanschluss (12), welcher auf der ersten Schicht (11) angeordnet ist und an dem ein erstes Potential (V1) abgreifbar ist,
- dem ersten Messanschluss (24) der zweiten Schicht (21), an dem ein zweites Potential (V2) abgreifbar ist, und
- einem Kompensationsanschluss (28), der auf der dritten Schicht (22) angeordnet ist und an dem ein drittes Potential (V3) abgreifbar ist, verbunden ist.

**12.** Messanordnung nach Anspruch 11,
**dadurch gekennzeichnet, dass**

- das erste und das dritte Potential (V1, V3) derart eingestellt sind, dass ein PN-Übergang zwischen der ersten und der dritten Schicht (11, 22) in Sperrrichtung gepolt ist, und
- das zweite und das dritte Potential (V2, V3) derart eingestellt sind, dass ein PN-Übergang (23) zwischen der zweiten und der dritten Schicht (21, 22) in Sperrrichtung gepolt ist.

**13.** Messanordnung nach Anspruch 11 oder 12,
**dadurch gekennzeichnet, dass**
die Schaltungsanordnung (50) einen ersten Verstärker (60) umfasst mit

- einem ersten Eingang (61), der mit dem ersten Messanschluss (24) gekoppelt ist,
- einem zweiten Eingang (62), der mit einem Bezugspotentialanschluss (8) gekoppelt ist, und
- einem Ausgang (63), der über eine erste Rückkoppelimpedanz (64) mit dem ersten Eingang (61) gekoppelt ist und an dem eine erste Ausgangsspannung (Va) abgreifbar ist.

**14.** Messanordnung nach Anspruch 9 und 13, **dadurch gekennzeichnet, dass** die Schaltungsanordnung (50) einen zweiten Verstärker (70) umfasst mit

- einem ersten Eingang (71), der mit dem zweiten Messanschluss (25) gekoppelt ist,
- einem zweiten Eingang (72), der mit dem Bezugspotentialanschluss (8) gekoppelt ist, und
- einem Ausgang (73), der über eine zweite Rückkoppelimpedanz (74) mit dem ersten Eingang (71) gekoppelt ist und an dem eine zweite Ausgangsspannung (Vb) abgreifbar ist.

**15.** Messanordnung nach Anspruch 10 und 14, **dadurch gekennzeichnet, dass** die Schaltungsanordnung (50)

- einen dritten Verstärker (80) mit

  - einem ersten Eingang (81), der mit dem dritten Messanschluss (26) gekoppelt ist,
  - einem zweiten Eingang (82), der mit dem Bezugspotentialanschluss (8) gekoppelt ist, und
  - einem Ausgang (83), der über eine dritte Rückkoppelimpedanz (84) mit dem ersten Eingang (81) gekoppelt ist und an dem eine dritte Ausgangsspannung (Vc) abgreifbar ist und

- einen vierten Verstärker (90) umfasst mit

  - einem ersten Eingang (91), der mit dem vierten Messanschluss (27) gekoppelt ist,
  - einem zweiten Eingang (92), der mit dem Bezugspotentialanschluss (8) gekoppelt ist, und
  - einem Ausgang (93), der über eine vierte Rückkoppelimpedanz (94) mit dem ersten Eingang (91) gekoppelt ist und an dem eine vierte Ausgangsspannung (Vd) abgreifbar ist.

**16.** Messanordnung nach einem der Ansprüche 13 bis 15, **dadurch gekennzeichnet, dass** die Schaltungsanordnung (50) eine Serienschaltung mit einer ersten Impedanz (65) und einer Diode (66) aufweist und die Serienschaltung zwischen den Ausgang (63) des ersten Verstärkers (60) und den Kompensationsanschluss (28) geschaltet ist.

**17.** Messanordnung nach Anspruch 14 und 16, **dadurch gekennzeichnet, dass** die Schaltungsanordnung (50) eine zweite Impedanz (75) aufweist, die zwischen den Ausgang (73) des zweiten Verstärkers (70) und einen Knoten zwischen der Diode (66) und der ersten Impedanz (65) geschaltet ist.

**18.** Verwendung einer Messanordnung nach einem der Ansprüche 14, 15 oder 17 zur Bestimmung einer Position des Auftreffortes einer auf die Photodetektoranordnung (1) auftreffenden Photonenstrahlung (ΦL).

**19.** Verfahren zum Betrieb einer Messanordnung mit einer Photodetektoranordnung (1), umfassend folgende Schritte:

- Bestrahlen der Photodetektoranordnung (1) mit einer Photonenstrahlung (ΦL),
- Erzeugen von Elektron-Loch-Paaren in einem Halbleiterkörper (2) der Photodetektoranordnung (1) in Folge der Photonenstrahlung (ΦL),
- Ermitteln eines Detektorstroms (Ia, Ib, Ic, Id, I1), der durch eine erste Schicht (11), die an einer ersten Hauptfläche (10) des Halbleiterkörpers (2) angeordnet ist, oder durch eine zweite Schicht (21), die an einer zweiten Hauptfläche (20) des Halbleiterkörpers (2) angeordnet ist, fließt,
- Bereitstellen eines Kompensationsstroms (I3) mit einem Wert, der ein vorgegebenes Verhältnis (Q) zu einem Wert des Detektorstroms (Ia, Ib, Ic, Id, 13) aufweist, und
- Zuführen des Kompensationsstroms (I3) an eine dritte Schicht (22), die zwischen der ersten und der zweiten Schicht (11, 21) in dem Halbleiterkörper (2) angeordnet ist.

**20.** Verfahren zur Herstellung einer Photodetektoranordnung (1), umfassend folgende Schritte:

- Bereitstellen eines Halbleiterkörpers (2) mit einem Substrat (3),
- Durchführen eines ersten Dotierungsschrittes (I1) an einer ersten Hauptfläche (10) des Halbleiterkörpers (2),
- Durchführen eines zweiten Dotierungsschrittes (I2) an einer zweite Hauptfläche (20) des Halbleiterkörpers (2), die zu der ersten Hauptfläche (10) entfernt liegt,
- Durchführen eines dritten Dotierungsschrittes (I3) an der zweiten Hauptfläche (20),
- Durchführen einer Temperung für eine Diffusion von Dotierstoffen zur Herstellung einer ersten Schicht (11) an der ersten Hauptfläche (10), einer zweiten Schicht (21) an der zweiten Hauptfläche (20) und einer dritten Schicht (22) zwischen dem Substrat (3) und der zweiten Schicht (21),
- Ausbilden eines Messanschlusses (24, 25, 26, 27) zur elektrischen Kontaktierung der zweiten Schicht (21) und eines Kompensationsanschlusses (28) zur elektrischen Kontaktierung der dritten Schicht (22) sowie
- Ausbilden einer Gesamtstromanschlusses (12) zur elektrischen Kontaktierung der ersten Schicht (11).

# FIG. 1

EP 1 837 919 A2

# FIG. 2

EP 1 837 919 A2

FIG. 3

**IN DER BESCHREIBUNG AUFGEFÜHRTE DOKUMENTE**

**In der Beschreibung aufgeführte Patentdokumente**

- WO 8404960 A
- EP 0513444 A1
- US 4887140 A
- US 4874939 A
- US 20040135224 A1